# EUROPEAN PATENT APPLICATION

(11) **EP 0 730 338 A1**
(43) Date of publication of application: **04.09.1996**
(21) Application number: 95830072.5
(22) Date of filing: 03.03.1995
(51) Int. Cl.: H02M 3/28, H01L 41/107

(54) **Piezoelectric double-polarization resonating transformer for low-power, high-voltage power supply**

(71) Applicant: SECI SUD S.r.l., I-80019 Qualiano (IT)
(72) Inventor: Gabriele, Claudio, I-10126 Torino (IT); Sacerdoti, Giancarlo, I-00144 Roma (IT)
(74) Representative: Sarpi, Maurizio

(57) **Abstract**

A transformer including a piezoelectric element formed by one or more bars of ceramic material or another technologically suitable material, and subjected in operation to electrical fields being constantly or mostly of the same sign and generated by electrical polarization means, said piezoelectric element being divided into two areas, the first area being associated to the primary of the transformer, and the second area being associated to the secondary of the same. Preferably, the piezoelectric element is formed of a multilayer construction including at least a pair of foils of ceramic material sandwiched by a conductive foil.

## Description

The present invention relates to the field of the electrotechnics and more particularly to a piezoelectric resonating transformer made of materials having an electrical starting polarization for use in a low-power, high-voltage power supply.

At the present state of art, high-voltage generators operating at more than 1000 volts and having a low power (some volt-ampere) are required for different applications. Transformers and generators of the type Marx & Cokchroft and Walton are often used and in most case they are the weak point of the whole apparatus.
The severe rules of IEC (International Electrotechnical Commission), with which such generators must comply, involve expensive solutions in order to avoid a too low MTBF (Mean Time Between Failures).
For saving reasons, ceramics or generally a ferroelectric material should be used as piezoelectric material in the form of bars which have to be initially polarized by strong electrical fields. The depolarization of the bars, which reduces the MTBF, is quickened during the operation if the bar is subjected to electrical fields oscillating between positive and negative values. The increase of the temperature is another factor which assists the depolarization of the ferroelectric material. Because of the poor thermal conductivity of the piezoelectric materials, even low dissipations may lead to an increase of the temperature such as to reduce the mechanical quality grade of the material. The present invention aims at providing a piezoelectric resonating transformer which can be an alternative solution to the conventional transformers.

According to the invention, a circuit is provided in which several ceramic parts and some portions thereof are subjected in operation to electrical fields always or mostly of the same sign, by arranging to this purpose an electrical polarization such as to overcome the problem of the depolarization caused by electrical fields of varying sign.
Two areas are determined in the piezoelectric element of ceramics or similar material of piezoelectric properties, the first one belonging to the primary of the transformer, the second one belonging to the secondary of the transformer. Such areas form the two ceramic portions in which the electrical polarization should be provided.

The generator may have two embodiments. In the first one the primary of the piezoelectric transformer is supplied by a constant-frequency generator equal to one of the longitudinal resonance frequencies of the bar (generally, the piezoelectric material is a bar or two bars of different section integral to each other). In the second one the generator is a part of an oscillator with negative feedback operating at a frequency equal to the resonance frequency of the piezoelectric bar. The negative feedback voltage is supplied from the output to the input of an amplifier according to well-known techniques. Filter circuits are provided for attenuating both the higher and lower frequencies than the selected frequency and avoiding an operation instability. The resonance frequency of the bar is directly depending on the longitudinal dimension thereof.
In order to minimize the negative influence of the temperature which causes the depolarization and at the same time to promote the initial polarization of the material, there is provided a bar block formed of several stacked layers such as a sandwich of piezoelectric material between conductive plates welded or glued to one another.

The invention will now be described with reference to the accompanying drawings which show by way of a non-limiting example a preferred embodiment of the invention.
In the drawings:
Fig. 1 shows schematically the operating principle of a piezoelectric transformer according to the known technique;
Fig. 2 shows the electrical circuit diagram of an oscillating resonating transformer according to the invention;
Fig. 3 shows a stabilized-amplitude drive circuit with input and output polarization;
Fig. 4 shows a qualitative diagram of the response curves of the ratio of transformation;
Fig. 5 shows the voltages in some nodes of Fig. 3;
Fig. 6 shows a preferred embodiment of a piezoelectric element of multilayer construction according to the invention.

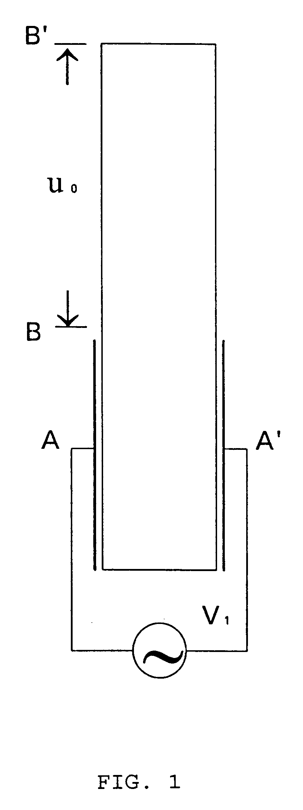

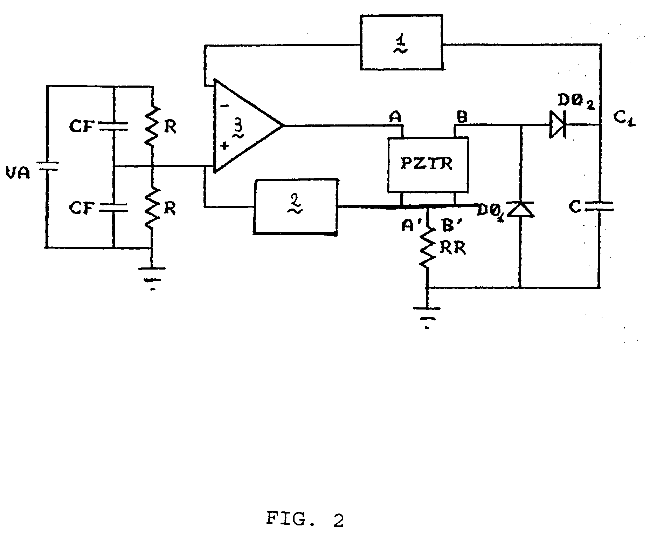

As known, the operation principle of a piezoelectric transformer is as follows:
Referring to figure 1, if a voltage having a frequency equal to the own longitudinal resonance frequency of the bar is applied between two electrodes A and A', a much higher output voltage appears between electrodes B and B' at least when a load of high resistance is connected between B and B'.
The schematic diagram of a self-oscillating resonating transformer according to the invention is shown in figure 2.
One input of amplifier 3 is supplied with a polarization voltage to which an a.c. negative feedback signal through feedback block 2 is summed. Amplifier 3 supplies the primary electrodes of the piezoelectric core of transformer PZTR. As well known, the equivalent impedance between such electrodes is that of a resonating circuit acting as a piezoelectric material.
The output voltage at B provides for the polarization of the piezoelectric material between electrodes B and B' by means of rectifier D0₁ so that an oscillating voltage superimposed to a d.c. polarization voltage is present at the output B. A d.c. voltage (to which a ripple is superimposed) is present at the output C₁ of a second diode D0₂ and capacitor C. Therefore, a voltage signal for stabilizing the output voltage level at C₁ is fed through feedback block 1 to the second (negative) input of the amplifier.

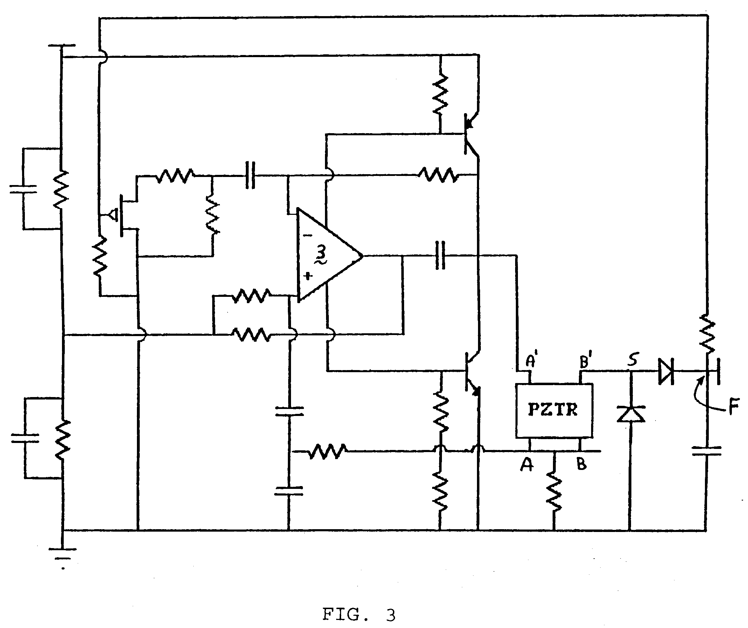

An alternative embodiment to the circuit diagram of figure 2 is shown in figure 3 by way of a further non-limiting example. The feedback circuit 2 attenuates the feedback at signals having a different frequency from that selected for the operation of the resonating transformer and corresponding to a particular own resonance frequency of the piezoelectric bar.
The circuit of figure 3 allows the output voltage of the resonating transformer used as direct current generator to be stabilized both by stabilizing the voltage by means of a negative d.c. feedback and by locking the operating frequency with a selective a.c. negative feedback.

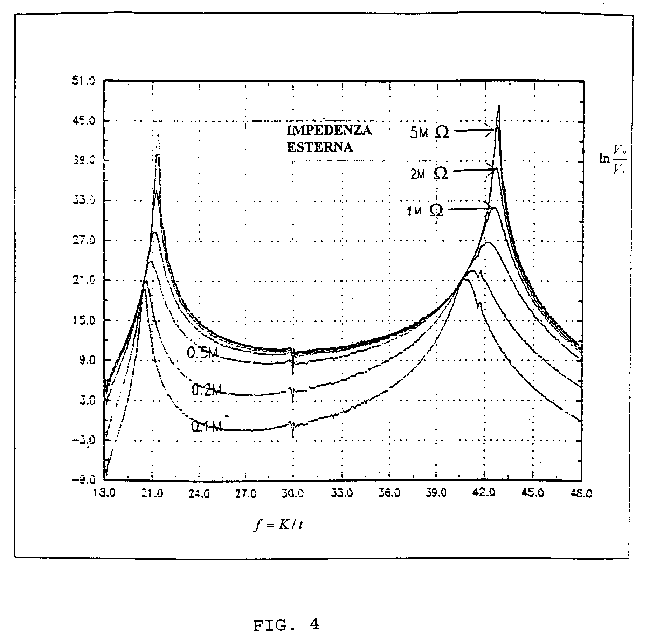

Figure 4 shows by way of example the response curves of the transformation ratio in decibel versus the supply frequency of the primary and the impedance in megaohm from the secondary.

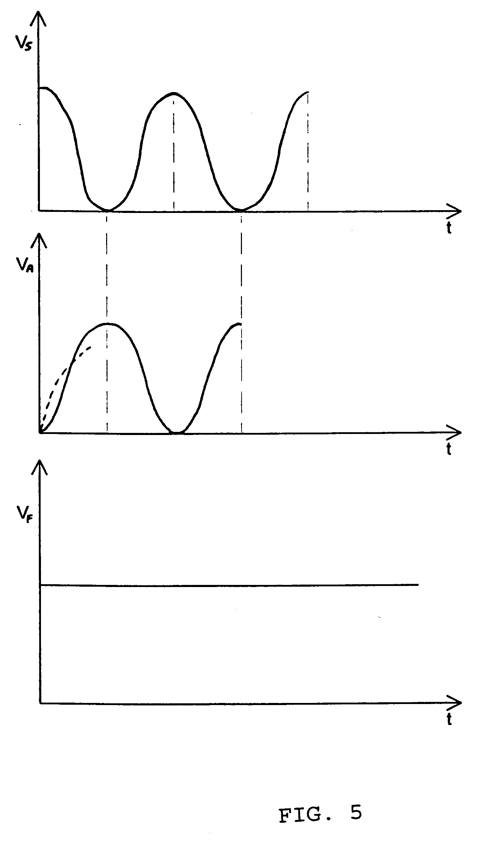

Finally, figure 5 shows diagrams illustrating more clearly the voltages at some peculiar nodes of the circuit of figure 3 (nodes S, A and F).

As mentioned above, the increase in the temperature has a negative influence on the depolarization of the ferroelectric material. Because of the poor thermal conductivity of the piezoelectric materials, even small dissipations can lead to an increase in the temperature such as to reduce the mechanical quality grade of the material.

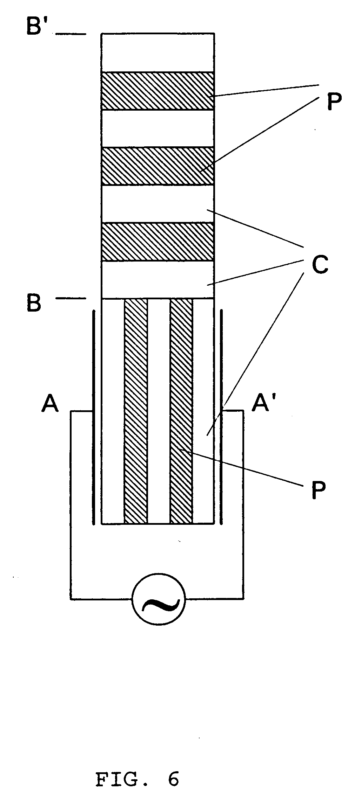

In order to reduce such effect and to promote also the polarization, another feature of the invention provides "bars" which are formed by a series of layers of piezoelectric material stacked on and made integral to one another (e.g. by gluing, welding, brazing, a.s.o.) and having a thickness between a few microns and several millimetres. Such bars are sandwiched by conductive foils having a thickness between 0,0001 and 1 mm. The latter can be made in several ways, for example by surface metal coating.
A possible form of the bars is that shown in figure 6 where the foils p of ferroelectric-piezoelectric material are sandwiched between conductive foils c for cooling purposes.
It should be appreciated that the foils takes on an uniform polarization, thus hindering the depolarization of the bar, if the thickness of the foils of piezoelectric material is reduced under a certain characteristic value, as it is the case for the ferromagnetic materials. Of course, the multilayer construction of piezoelectric material sandwiched by conductive layers can have several configurations. In addition to the bars or foils one can provide cylindrical or conical constructions, the former including concentric cylindrical tubes, the latter being upset within one another.

## Claims

1. A piezoelectric resonating transformer, wherein it includes materials having an electrical starting polarization, as it is the case for the ceramic materials, the electrical fields associated to the operation of the transformer having still the same sign both in the material associated to the primary circuit and in the material associated to the secondary circuit of the transformer.

2. The transformer according to claim 1, wherein it includes means for keeping the polarity of the electrical field in the material associated to the primary circuit unchanged.

3. The transformer according to claims 1 and 2, wherein it includes electronic means for keeping the polarity of the electrical field in the material associated to the secondary circuit unchanged.

4. The transformer according to claims 1 to 3, wherein the stability of the output voltage is achieved by a negative voltage feedback circuit so as to regulate the amplification.

5. The transformer according to claims 1 to 4, wherein the operative frequency is locked to a resonance frequency of the piezoelectric bar by providing a negative feedback to the oscillator by means of frequency-selective circuits so as to avoid further oscillation modes and/or frequencies.

6. The transformer according to claims 1 to 5, wherein the piezoelectric bar is formed of one piece polarized to different directions according to the parts associated to the primary and the secondary circuits, respectively.

7. The transformer according to claims 1 to 6, wherein the piezoelectric bar is formed by two parts joined together, each part being polarized independently from each other.

8. The transformer according to claims 1 to 7, wherein the two parts forming the piezoelectric bar are joined together by gluing or welding.

9. The transformer according to claims 1 to 8, wherein the piezoelectric element is made by stacking a plurality of elements of piezoelectric material of the ferroelectric type which are sandwiched by metal layers having the double function of promoting the cooling and the polarization.

10. The transformer according to claim 9, wherein the piezoelectric element is formed of a succession of elements in the form of concentric cylindrical tubes and coaxial cylindrical or conical elements upset within one another.

11. A piezoelectric resonating transformer according to claim 1, wherein it is driven by an outer oscillator having a fixed frequency.
